# EUROPEAN PATENT APPLICATION

(11) **EP 4 318 609 A1**
(43) Date of publication of application: **07.02.2024**
(21) Application number: 21938905.3
(22) Date of filing: 25.10.2021
(51) Int. Cl.: H01L 31/18, H01L 31/068

(54) **PREPARATION METHOD FOR SOLAR CELL AND SILICON FILM**

(30) Priority: 26.04.2021 CN 202110456104
(71) Applicant: Ja Solar Technology Yangzhou Co., Ltd., Yangzhou, Jiangsu 225131 (CN)
(72) Inventor: TANG, Wenshuai, Yangzhou, Jiangsu 225131 (CN); ZHANG, Junbing, Yangzhou, Jiangsu 225131 (CN); SUN, Xiaolu, Yangzhou, Jiangsu 225131 (CN)
(74) Representative: Sun, Yiming
(86) International application number: PCT/CN2021/126031
(87) International publication number: WO 2022/227442

(57) **Abstract**

The technical solution discloses a preparation method for a solar cell and a silicon film. The preparation method comprises: forming a dielectric layer on a first main surface of a silicon substrate; forming a silicon film having a first conductive characteristic on the dielectric layer, the silicon film including a first region and a second region located outside the first region; and transforming the conductive characteristic of the first region from the first conductive characteristic to a second conductive characteristic, the first conductive characteristic being opposite to the second conductive characteristic. The preparation method simplifies a solar cell manufacturing process.

## Description

The application claims priority to CN Patent Application No. 202110456104.3, entitled "Preparation Method for Solar Cell and Silicon Film", which was filed on April 26, 2021, and the contents of which are hereby incorporated by reference in its entirety to serve as part of the application.

### Technical Field

The disclosure relates to a preparation method for a solar cell and a silicon film.

### Background

A full rear contact (FRC) solar cell (hereinafter referred to as the FRC cell) is a solar cell in which p+ doped regions and n+ doped regions are arranged alternately on the rear surface (non-light-receiving surface) of the cell. The light-receiving surface of the FRC cell is not blocked by any metal electrode, which effectively increases the short-circuit current of the cell and improves the energy conversion efficiency of the cell.

Since all the electrodes of the FRC cell are located on the rear surface of the silicon substrate, it is required to form two kinds of different doped regions that are arranged alternately on the rear surface of the silicon substrate. In the current preparation process of the solar cells of the FRC type, in order to achieve formation of two kinds of different doped regions that are arranged alternately on the rear surface of the silicon substrate, it is required to introduce a photolithography masking technique, a laser etching manner and a secondary diffusion method into the doping process and the metallization process, for example, using the photolithography masking technique and the laser etching manner to separate p+ doped regions and n+ doped regions for the silicon substrate, and using the secondary diffusion method to successively perform corresponding doping and doping material activating steps in the separated p+ doped regions and n+ doped regions, and it is required to arrange an isolation region or isolation layer between the p+ doped region and the n+ doped region that are adjacent, so that different doped regions are isolated. As a result, the existing FRC cell preparation process steps are comparatively complicated, and the production efficiency is comparatively low.

### Summary

In view of this, the technical problem to be solved by the disclosure lies in providing a preparation method for a solar cell and a silicon film, which can effectively simplify the FRC cell manufacturing process, and effectively improve the FRC cell production efficiency.

In order to solve the aforesaid technical problem, the disclosure provides the following technical solution:
According to a first aspect, the disclosure provides a preparation method for a solar cell, comprising:
step (a): forming a dielectric layer on a first main surface of a silicon substrate;
step (b): forming a silicon film having a first conductive characteristic on the dielectric layer, the silicon film including a first region and a second region located outside the first region; and
step (c): transforming the conductive characteristic of the first region from the first conductive characteristic to a second conductive characteristic, the first conductive characteristic being opposite to the second conductive characteristic.

According to a second aspect, the disclosure provides a preparation method for a silicon film, comprising:
step (a'): forming a silicon film having a first conductive characteristic, the silicon film including a first region and a second region located outside the first region; and
step (b'): transforming the conductive characteristic of the first region from the first conductive characteristic to a second conductive characteristic, the first conductive characteristic being opposite to the second conductive characteristic.

The aforesaid technical solution according to the first aspect of the disclosure has the following advantages or beneficial effects: by growing a dielectric layer on the first main surface of the silicon substrate and forming a silicon film having a first conductive characteristic on the dielectric layer, the first conductive characteristic of the solar cell may be preliminarily formed, and further by transforming the conductive characteristic of the first region included in the silicon film from the first conductive characteristic to a second conductive characteristic, the first conductive characteristic being opposite to the second conductive characteristic, it is achieved that a second region having the first conductive characteristic and a first region having the second conductive characteristic are prepared in the same silicon film, which effectively simplifies the FRC cell manufacturing process, and effectively improves the FRC cell production efficiency.

In addition, since the first region having the first conductive characteristic and the second region having the second conductive characteristic belong to the same silicon film, by transforming the conductive characteristic of the first region from the first conductive characteristic to the second conductive characteristic without complicated processes such as photolithography masking, laser etching, secondary diffusion, etc., the FRC cell is made to be more conducive to industrialization and mass production.

### Brief Description of the Drawings

FIG. 1 is a schematic diagram of a main flow of a preparation method for a solar cell according to an embodiment of the disclosure;
FIG. 2 is a schematic diagram of a cross-sectional structure including a silicon substrate and a dielectric layer according to an embodiment of the disclosure;
FIG. 3 is a schematic diagram of a cross-sectional structure including a silicon substrate, a dielectric layer and a silicon film according to an embodiment of the disclosure;
FIG. 4A is a schematic diagram of a planar structure of a template according to an embodiment of the disclosure;
FIG. 4B is a schematic diagram of a planar structure of a relationship between a template and a silicon film in a process of preparing a solar cell according to an embodiment of the disclosure;
FIG. 5A is a schematic diagram of a planar structure of a relationship between a mask and a silicon film in a process of preparing a solar cell according to an embodiment of the disclosure;
FIG. 5B is a schematic diagram of a cross-sectional structure of a relationship between a mask/template and a silicon film in a process of preparing a solar cell according to an embodiment of the disclosure;
FIG. 6A is a schematic diagram of a concentration change of doping a first region with a second type of doping material according to an embodiment of the disclosure;
FIG. 6B is a schematic diagram of a relationship between a first region and a second region according to one embodiment of the disclosure;
FIG. 7A is a schematic diagram of a partial cross-section of a first main conductive region and a first isolation region included in a first region according to an embodiment of the disclosure;
FIG. 7B is a schematic diagram of a partial cross-section of a second main conductive region and a second isolation region included in a second region according to an embodiment of the disclosure;
FIG. 7C is a schematic diagram of a partial cross-section of a relative positional relationship among a first main conductive region, a first isolation region, a second main conductive region and a second isolation region according to an embodiment of the disclosure;
FIG. 8 is a schematic diagram of a partial cross-section of a solar cell according to an embodiment of the disclosure;
FIG. 9 is a schematic diagram of a partial cross-section of a solar cell according to another embodiment of the disclosure;
FIG. 10 is a schematic diagram of a cross-section of a solar cell component according to an embodiment of the disclosure; and
FIG. 11 is a schematic diagram of a main flow of a preparation method for a silicon film according to an embodiment of the disclosure.

The reference signs are given as follows:
10 silicon substrate
20 dielectric layer
30 silicon film
31 first region
311 first main conductive region, 312 first isolation region
32 second region
321 second main conductive region, 322 second isolation region
40 passivation anti-reflection film
50 metal electrode
60 rear plate
70 cover plate
80 template structure
90 mask

### Detailed Description

A silicon substrate may be an n-type silicon substrate (also known as an electron-type silicon substrate) or a p-type silicon substrate. As a substrate material of a solar cell, the n-type silicon substrate or the p-type silicon substrate (hereinafter referred to as the silicon substrate) is generally in the shape of a sheet, and the silicon substrate generally includes two main surfaces (that is, a first main surface and a second main surface below). When the silicon substrate is used in a solar cell, one of the main surfaces (such as the first main surface below) may be used as the rear surface of the silicon substrate, and correspondingly, the other main surface (such as the second main surface below) may be used as the front surface of the silicon substrate, wherein the rear surface of the silicon substrate refers to a main surface facing away from sunlight when the silicon substrate is used in the solar cell, and the front surface of the silicon substrate refers to a main surface facing sunlight when the silicon substrate is used in the solar cell. The preparation method is described below mainly by taking it as an example that the first main surface is used as the rear surface and the second main surface is used as the front surface. The first main surface may also be used as the front surface, correspondingly, the second main surface may also be used as the rear surface, and no unnecessary details are further given herein.

A conductive characteristic refers to a p-type conductive characteristic formed by generating a large number of holes capable of accommodating electrons on the silicon film, or, an n-type conductive characteristic formed by generating a large number of free electrons on the silicon film, wherein the p-type conductive characteristic is opposite to the n-type conductive characteristic.

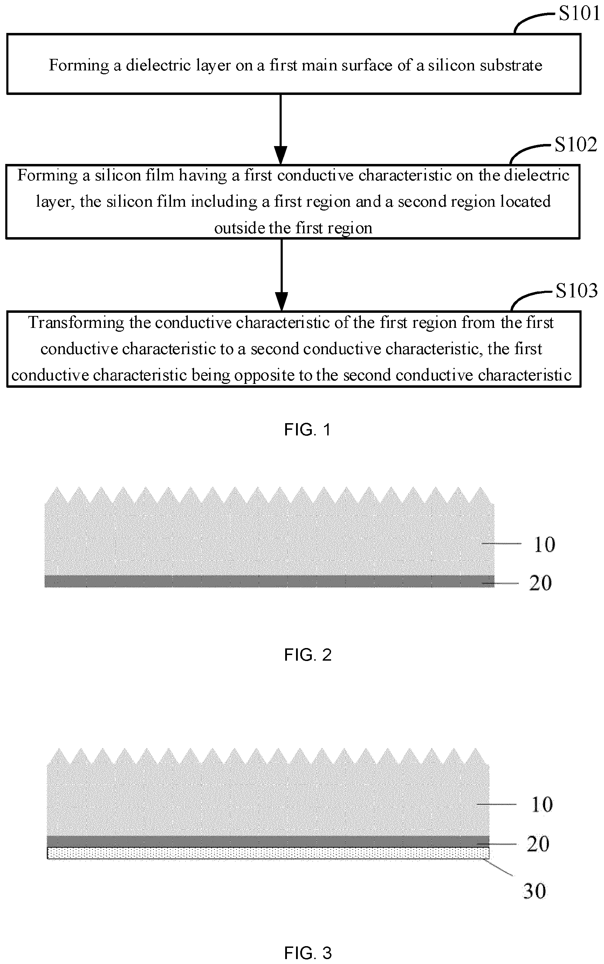

As shown in FIG. 1, the embodiment of the disclosure provides a preparation method for a solar cell, which may comprise the following steps:
Step S101: Forming a dielectric layer on a first main surface of a silicon substrate;
By the step S101, a schematic diagram of a cross-sectional structure including a silicon substrate 10 and a dielectric layer 20 as shown in FIG. 2 is obtained. In the silicon substrate 10 and the dielectric layer 20 as shown in FIG. 2, the dielectric layer 20 is laid flat on the first main surface of the silicon substrate 10, and the dielectric layer may passivate the first main surface of the silicon substrate so as to improve the photoelectric conversion effect of the solar cell.

The specific implementation scheme of the step S101 may include: in a manner of a low pressure chemical deposition (the full name of the low pressure chemical deposition is a low pressure chemical vapor deposition, and the low pressure chemical deposition below refers to the low pressure chemical vapor deposition), a single-layer dielectric film or a stacked dielectric film is grown on the first main surface of the silicon substrate, wherein the single-layer dielectric film or the stacked dielectric film may include: one or more of silicon oxide, titanium oxide and silicon oxynitride. The stacked dielectric film is obtained by stacking a plurality of single-layer dielectric films. Specifically, the stacked dielectric film includes one or more of silicon oxide, titanium oxide and silicon oxynitride. The case may be that each single-layer dielectric film included in the stacked dielectric film includes one or more of silicon oxide, titanium oxide and silicon oxynitride; or the case may also be that each single-layer dielectric film included in the stacked dielectric film includes one of silicon oxide, titanium oxide and silicon oxynitride. Wherein the low pressure chemical vapor deposition (LPCVD) has been applied to solar cell preparation, and in the process of depositing the dielectric layer using the LPCVD in the embodiment of the disclosure, existing LPCVD control parameters may be selected for the achievement.

The thickness of the single-layer dielectric film or the stacked dielectric film ranges from 0.5 nm to 2.5 nm. It is worth noting that the thickness of the stacked dielectric film refers to a total thickness of the stacked dielectric film. For example, if the dielectric layer 20 includes a silicon oxide film, a titanium oxide film and a silicon oxynitride film that are stacked, the thickness of the stacked dielectric film refers to a sum of the thickness of the silicon oxide film, the thickness of the titanium oxide film and the thickness of the silicon oxynitride film. The thickness of the single-layer dielectric film or the stacked dielectric film ranges from 0.5 nm to 2.5 nm, which may effectively ensure the performance of the FRC. According to a research, the performance of the FRC will be reduced if the thickness of the dielectric layer is lower than 0.5 nm or higher than 2.5 nm.

Step S102: Forming a silicon film having a first conductive characteristic on the dielectric layer, the silicon film including a first region and a second region located outside the first region;

It is worth noting that the first conductive characteristic may be a P-type conductive characteristic or an N-type conductive characteristic, and correspondingly, the second conductive characteristic in the step S103 below is opposite to the first conductive characteristic. For example, if the first conductive characteristic is the P-type conductive characteristic, the second conductive characteristic is correspondingly the N-type conductive characteristic; if the first conductive characteristic is the N-type conductive characteristic, the second conductive characteristic is correspondingly the P-type conductive characteristic. A silicon film having the P-type conductive characteristic refers to a silicon film having the P-type conductive characteristic formed by adding boron, a doping material that increases the number of positive charge carriers, to the silicon film. A silicon film having the N-type conductive characteristic refers to a silicon film having the N-type conductive characteristic formed by adding phosphorus, a doping material that increases the number of negative charge carriers (electrons), to the silicon film.

That is, the step may obtain the silicon film having the first conductive characteristic by depositing a silicon film having a first type of doping material on the dielectric layer. For example, if the first type of doping material is boron and other doping materials that may increase the number of the positive charge carriers, the silicon film may be made to have the P-type conductive characteristic; for another example, if the first type of doping material is phosphorus and other doping materials that may increase the number of negative charge carriers (electrons), the silicon film may be made to have the N-type conductive characteristic.

Specifically, there are two implementation schemes to deposit a silicon film having the first type of doping material on the dielectric layer.

The first implementation scheme to deposit the silicon film having the first type of doping material on the dielectric layer is as follows:
First, a silicon film is deposited on the dielectric layer; then, the silicon film is doped with the first type of doping material in a diffusion or ion implantation manner and the like.

The second implementation scheme to deposit the silicon film having the first type of doping material on the dielectric layer is as follows:
A silicon film is deposited on the dielectric layer, and the silicon film is doped with the first type of doping material in an in-situ doping manner. The second implementation scheme makes the process of forming the silicon film having the first conductive characteristic simpler and more efficient, which provides a support for the simplification of the solar cell preparation process.

Wherein a plasma enhanced chemical vapor deposition (PECVD) may be used in the depositing process. The PECVD makes a gas containing film-constituting atoms locally form a plasma by means of microwaves or radio frequencies and the like, and the plasma is very chemically active and easily undergoes a reaction to deposit the desired film on the substrate. The PECVD has been applied to solar cell preparation. In the embodiment of the disclosure, in the process of using the PECVD to dope intrinsic silicon (which may be any one of polycrystalline silicon, amorphous silicon, and microcrystalline silicon) with the first doping material in an in-situ doping manner, the achievement may be made by modulating PECVD operating parameters.

After the step S102, a schematic diagram of a cross-sectional structure including a silicon substrate 10, a dielectric layer 20 and a silicon film 30 having a first conductive characteristic as shown in FIG. 3 is obtained. It may be seen from FIG. 3 that the silicon film 30 having the first conductive characteristic is located on the dielectric layer 20. The fact that the silicon film 30 having the first conductive characteristic is located on the dielectric layer 20 does not specifically refer to that the silicon film 30 is located above the dielectric layer 20, but refers to that the silicon film 30 covers the surface of the dielectric layer 20. A silicon film having a conductive characteristic may be directly obtained by the process, and it may be subsequently obtained that regions having opposite conductive characteristics are arranged alternately on the first main surface of the silicon substrate by changing the conductive characteristics of some regions of the silicon film. For example, it may be obtained by subsequent steps that the P+ doped regions and the N+ doped regions are arranged alternately on the first main surface of the silicon substrate.

In the above step, the silicon film may include: a single-layer film or a stacked film formed of one or more of microcrystalline silicon, amorphous silicon, and polycrystalline silicon. In addition, the silicon film may further include: silicon oxide and/or silicon carbide. That is, the silicon oxide and/or silicon carbide may be added to the single-layer film or the stacked film formed of one or more of microcrystalline silicon, amorphous silicon, and polycrystalline silicon.

In addition, in the step S102, the silicon film may be divided into the first region 31 and the second region 32, so that the silicon film includes the first region 31 and the second region 32 located outside the first region 31. The silicon film includes a plurality of first regions 31 and a plurality of second regions 32; the plurality of first regions 31 and the plurality of second regions 32 are arranged alternately.

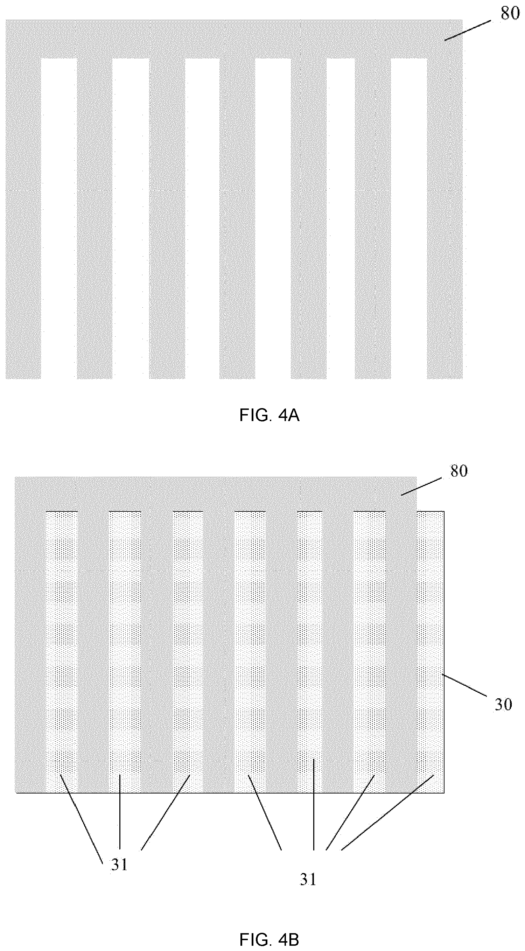

Wherein the specific implementation scheme of dividing the silicon film into the first region 31 and the second region 32 may be covering a template structure 80 as shown in FIG. 4A on the silicon film 30 to obtain the surface structure of the silicon film 30 covered by the template structure 80 as shown in FIG. 4B. Then, in the silicon film 30, the region not covered by the template structure 80 is just the first region 31 obtained by division, and the region covered by the template structure 80 is just the second region. It is worth noting that the aforesaid template structure 80 may be of any shape, and FIG. 4A only exemplarily gives one template structure.

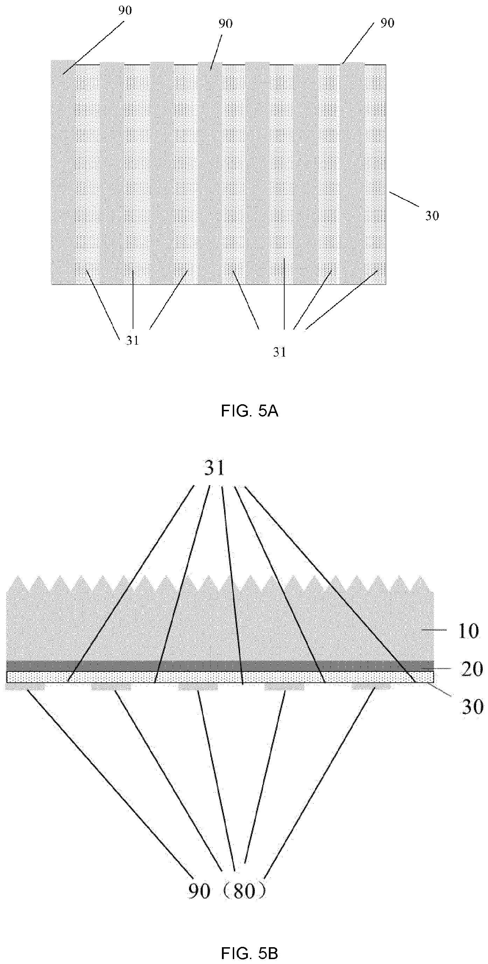

In addition, a mask 90 may also be used in place of the aforesaid template structure, then, the silicon film 30 covered by the mask may be as shown in FIG. 5A. As shown in FIG. 5A, the region not covered by the mask 90 is just the first region 31 obtained by dividing the silicon film 30, and the region covered by the mask is just the second region. In addition, in the cross-sectional view of the mask or template as shown in FIG. 5B, the region not covered by the mask or template is just the first region 31 obtained by dividing the silicon film 30, and the region covered by the mask or template is just the second region 32.

In the entire preparation process for the solar cell, a mask or template structure is introduced only once in the division of silicon film into the first region and the second region, which further shows that the embodiment of the disclosure simplifies the solar cell preparation process as compared with the existing solar cell production process that requires the introduction of the mask or template structure several times.

It is worth noting that the embodiment of the disclosure exemplarily illustrates a condition in which a plurality of first regions and a plurality of second regions are arranged alternately, and other arrangements of the first regions and the second regions on the silicon film may also be obtained by the aforesaid dividing manner.

Step S103: Transforming the conductive characteristic of the first region from the first conductive characteristic to a second conductive characteristic, the first conductive characteristic being opposite to the second conductive characteristic.

The specific implementation scheme of the step S103 may include: doping the first region with a second type of doping material in an ion implantation manner, the doping concentration of the second type of doping material being greater than the doping concentration of the first type of doping material.

The essence of the fact that the doping concentration of the second type of doping material is greater than the doping concentration of the first type of doping material is that the number of holes generated by the second type of doping material in the first region is greater than the number of free electrons generated by the first type of doping material in the first region, or, the number of free electrons generated by the second type of doping material in the first region is greater than the number of holes generated by the first type of doping material in the first region.

It is worth noting that in the aforesaid step S102, the silicon film is doped with the first type of doping material in an in-situ doping manner, and the first type of doping material is distributed in the thickness direction of the silicon film, so the measurement unit of the doping concentration of the first type of doping material is generally atoms/cm³. In the step S103, the first region is doped with the second type of doping material in an ion implantation manner, the second type of doping material implanted in an ion implantation manner is mainly distributed on the surface of the silicon film (that is, before activation, the second type of doping material is mainly distributed on the surface of the silicon film), and in the activation process, the second type of doping material will migrate in the thickness direction of the silicon film, so the measurement unit of the second type of doping material implanted in an ion implantation manner is generally atoms/cm². That the doping concentration of the second type of doping material is greater than the doping concentration of the first type of doping material as mentioned above may refer to that the doping concentration after converting the measurement unit of the second type of doping material implanted in an ion implantation manner (before activation) from atoms/cm² to atoms/cm³ according to the thickness of the silicon film and the area of the first region is greater than the doping concentration of the first type of doping material. That the doping concentration of the second type of doping material is greater than the doping concentration of the first type of doping material as mentioned above may also refer to that after the second doping material and the first doping material are activated, the doping concentration of the second doping material in the middle region of the first region is greater than the doping concentration of the first type of doping material. The middle region of the first region refers to a region covered by an ion beam in the process of implanting the second doping material in an ion implantation manner.

Wherein an ion beam used for ion implantation (for example, an ion beam with energy of 100 keV) is incident into a material, the ion beam is subjected to a series of physical and chemical interactions with the atoms or molecules in the material, and the incident ions gradually lose energy, finally stay in the material, and cause changes in the surface composition, structure and performance of the material, thereby optimizing the surface performance of the material, or obtaining some new excellent performances. The ion implantation has been applied to solar cell preparation, and in the embodiment of the disclosure, the existing operating parameters of the ion implantation manner may be used in the process of implanting the second type of doping material into the silicon film in an ion implantation manner.

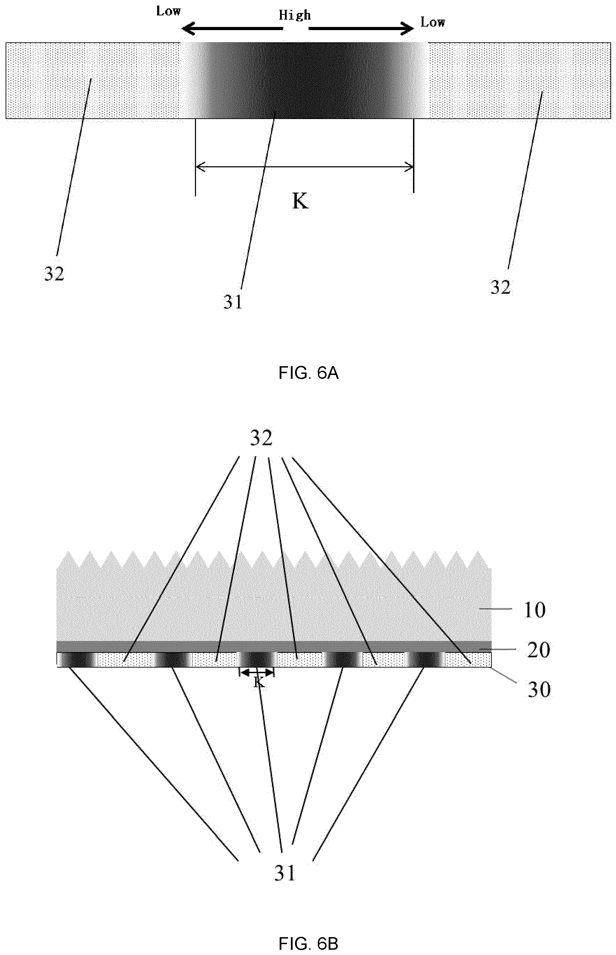

After the step S103, the concentration distribution diagram of the second type of doping material as shown in FIG. 6A and the partial structure of the solar cell as shown in FIG. 6B can be obtained. It can be seen from FIG. 6A that according to the direction shown by the arrow, in the process of doping the first region 31 with the second type of doping material in an ion implantation manner, the concentration of the second type of doping material with which the first region 31 is doped gradually decreases from the middle to the adjacent second region 32, the concentration of the second type of doping material in the middle region of the first region 31 is higher than the concentration of the first type of doping material, and as the gradual decrease of the concentration of the second type of doping material from the middle to the adjacent second region 32, since the concentration of the second type of doping material is equivalent to the concentration of the first type of doping material in the region at the boundary between the second region 32 and the first region 31, the region at the boundary between the second region 32 and the first region 31 is electrically neutral (that is, the conductive characteristic of the second type of doping material is offset by the conductive characteristic of the first type of doping material in the region at the boundary between the second region 32 and the first region 31, and the conductive characteristic of the second type of doping material being offset by the conductive characteristic of the first type of doping material refers to that in a case where the second type of doping material mainly generates holes and the first type of doping material mainly generates free electrons, most of the holes generated by the second type of doping material may accommodate most of the free electrons generated by the first type of doping material; in a case where the second type of doping material mainly generates free electrons and the first type of doping material mainly generates holes, most of the free electrons generated by the second type of doping material can enter most of the holes generated by the first type of doping material), thereby achieving electrical isolation between the first region and the second region. The region at the boundary between the second region 32 and the first region 31 may be: a part, which belongs to the second region 32, adjacent to the first region 31 (that is, as for the ion implantation manner, part of the second doping material will enter part of the second region 32, and the second type of doping material entering the second region 32 and the first type of doping material are made to offset each other to result in electrical neutrality by modulating the concentration of the second type of doping material entering the second region 32); the region at the boundary between the second region 32 and the first region 31 may also be: a part, which belongs to the first region 31, adjacent to the second region 32.

The transformation of the conductive characteristic of the first region 31 from the first conductive characteristic to the second conductive characteristic may be achieved by modulating the concentration of the second type of doping material with which the first region 31 is doped. That is, first, the free electrons generated by the first type of doping material with which the first region is doped are offset by the holes generated by the second type of doping material with which the first region 31 is doped, or, first, the holes generated by the first type of doping material with which the first region is doped are offset by the free electrons generated by the second type of doping material with which the first region is doped; then, as the increase of the concentration of the second type of doping material, the first region may exhibit the conductive characteristic that can be generated by the second type of doping material. For example, the second type of doping material such as boron mainly generates holes after the silicon film is doped with it, and the first type of doping material such as phosphorus mainly generates free electrons after the silicon film is doped with it, so as the increase of the concentration of the second type of doping material in the first region, the conductive characteristic of the first region may be transformed from the N-type conductive characteristic to the P-type conductive characteristic. For another example, the second type of doping material such as phosphorus mainly generates free electrons after the silicon film is doped with it, and the first type of doping material such as boron mainly generates holes after the silicon film is doped with it, so as the increase of the concentration of the second type of doping material in the first region, the conductive characteristic of the first region may be transformed from the P-type conductive characteristic to the N-type conductive characteristic.

That is, the first type of doping material is a doping material such as phosphorus that forms the N-type conductive characteristic, and the second type of doping material is a doping material such as boron that forms the P-type conductive characteristic; or, the first type of doping material is a doping material such as boron that forms the P-type conductive characteristic, and the second type of doping material is a doping material such as phosphorus that forms the N-type conductive characteristic.

In addition, in the embodiment, the doping concentration of the first type of doping material that may be modulated in the silicon film ranges from 1.0×10¹⁹ atoms/cm³ to 2.0×10²¹ atoms/cm³; the doping concentration of the second type of doping material that may be modulated in the silicon film ranges from 1.0×10¹⁹ atoms/cm³ to 2.0×10²¹ atoms/cm³; it is worth noting that the doping concentration of the second type of doping material in the silicon film is generally not lower than the doping concentration of the first type of doping material in the silicon film so as to achieve the transformation of the conductive characteristic of the first region. In addition, as for the second type of doping material implanted in an ion implantation manner, the measurement unit thereof is atoms/cm², and in the activation process, the second type of doping material will migrate in the thickness direction of the silicon film, so the doping concentration of the second type of doping material may refer to a doping concentration after transforming the measurement unit of the second type of doping material implanted in an ion implantation manner (before activation) from atoms/cm² to atoms/cm³ according to the thickness of the silicon film and the area of the first region, or, the doping concentration of the second doping material in the middle region of the first region after the activation. The middle region of the first region refers to a region covered by an ion beam in the process of implanting the second doping material in an ion implantation manner.

In addition, since the ion implantation manner will cause the concentration of the middle region to be high, the aforesaid doping concentration of the second type of doping material refers to an average concentration of the middle region K in the first region 31 as shown in FIG. 6A and FIG. 6B.

In addition, after a part of the second type of doping material offsets the conductive characteristic of the first type of doping material, the remaining part of the second type of doping material can exhibit the second conductive characteristic, and the aforesaid doping concentration of the second type of doping material in the silicon film refers to a doping concentration of the first type of doping material of the remaining part that can exhibit the second conductive characteristic.

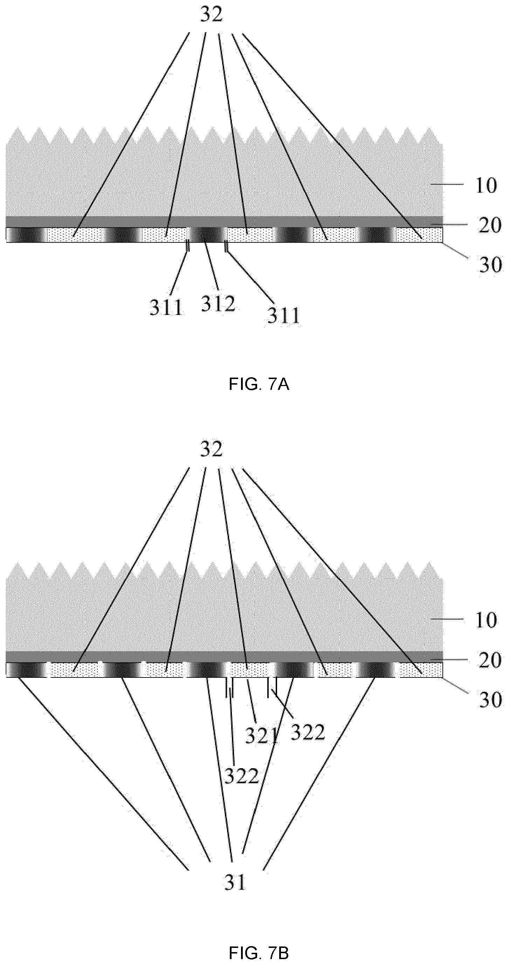

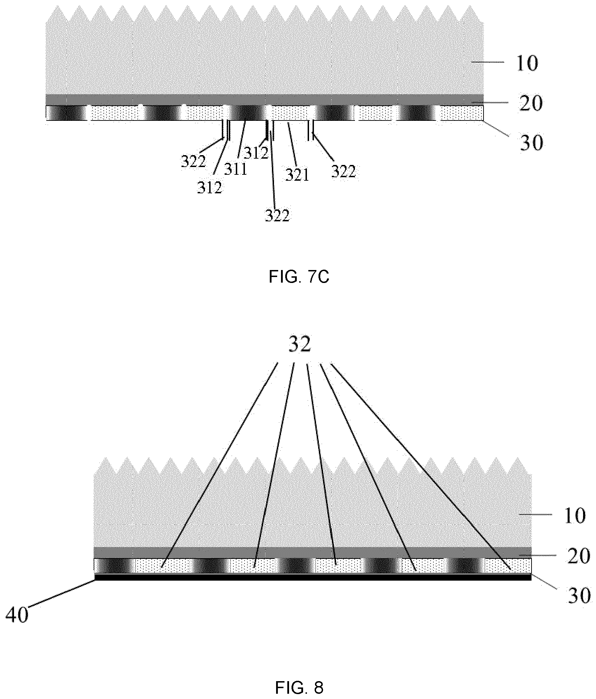

After the aforesaid step S103, it is required to remove the template or mask in the aforesaid step S102, and the removing manner may be achieved by an existing process. The solar cell structure after removing the template or mask may be as shown in FIG. 7A to FIG. 7C. That is, the isolation region may be formed in a region at the boundary between the first region and the second region. Specifically, as shown in FIG. 7A, in the first region 31, the middle region is a first main conductive region 311, and there may be part of the region on a side adjacent to the second region 32 having the conductive characteristic being offset, thereby forming a transition region (that is, a first isolation region 312 is formed in the first region) to achieve electrical isolation between the first region and the second region. As shown in FIG. 7B, in the second region 32, the middle region is a second main conductive region 321, and there may be part of the region on a side adjacent to the first region 31 having the conductive characteristic being offset, thereby forming a transition region (that is, a second isolation region 322 is formed in the second region) to achieve electrical isolation between the first region and the second region. As shown in FIG. 7C, in the first region 31, the middle region is the first main conductive region 311, and there may be part of the region on a side adjacent to the second region 32 having the conductive characteristic being offset, thereby forming a transition region (that is, the first isolation region 312 is formed in the first region), and meanwhile in the second region 32, the middle region is the second main conductive region 321, and there may be part of the region on a side adjacent to the first region 31 having the conductive characteristic being offset, thereby forming a transition region (that is, the second isolation region 322 is formed in the second region), that is, the first isolation region 312 is formed in the first region and the second isolation region 322 is formed in the second region at the same time, thereby achieving electrical isolation between the first region and the second region. In the aforesaid transition region (the first isolation region 312 and/or the second isolation region 322), since the two doping concentrations are close, the conductive characteristic is neutral (the conductive characteristic of the first type of conductive material and the conductive characteristic of the second type of material offset each other).

After doping with the first type of doping material in the aforesaid step S102 and/or after doping with the second type of doping material in the aforesaid step S104, the doping material (the doping material refers to the first type of doping material and/or the second type of doping material) with which the silicon film is doped may be further activated in an annealing manner. That is, the activation of the doping material which with the silicon film is doped in the annealing manner may be performed twice, respectively after the step S102 and after the step S104, to activate the first type of doping material and the second type of doping material, respectively. The activation of the doping material which with the silicon film is doped in the annealing manner may also be performed only once, after the step S104, to activate the first type of doping material and the second type of doping material at the same time. By the activation step, the solar cell may be made to have a better conductive characteristic. The annealing temperature ranges from 800 to 1000°C. That is, the annealing temperature may be any value between 800 and 1000°C, and by controlling the annealing temperature within the range of 800-1000°C, activation of the doping material may be ensured and resource waste may be avoided at the same time.

In the embodiment of the disclosure, the aforesaid preparation method for a solar cell may further comprise: depositing passivation anti-reflection films 40 on a second main surface of the silicon substrate 10 and the silicon film 30, respectively. Specifically, as shown in the schematic diagram of the cross-sectional structure after the passivation anti-reflection films are deposited in the solar cell preparation process in FIG. 8, the passivation anti-reflection films 40 are deposited on the second main surface of the silicon substrate 10 and the silicon film 30, respectively; since the first region and the second region belong to the same silicon film, in the process of depositing the passivation anti-reflection films, it is not necessary to deposit the passivation anti-reflection films for the first region and the second region, respectively, which further simplifies the preparation process for a solar cell.

It may be understood that depositing the passivation anti-reflection film 40 on the second main surface of the silicon substrate 10 and depositing the passivation anti-reflection film 40 on the silicon film 30 may be performed in two steps, that is, it is allowed to first deposit the passivation anti-reflection film 40 on the front surface of the silicon substrate 10, and then deposit the passivation anti-reflection film 40 on the silicon film 30, or it is also allowed to first deposit the passivation anti-reflection film 40 on the silicon film 30, and then deposit the passivation anti-reflection film 40 on the front surface of the silicon substrate 10.

Wherein the passivation anti-reflection film may include: any one or more of silicon nitride, silicon oxide, silicon oxynitride and aluminum oxide.

Specifically, the passivation anti-reflection film 40 deposited on the second main surface of the silicon substrate 10 and the passivation anti-reflection film 40 deposited on the silicon film 30 may be passivation anti-reflection films with different compositions. Specifically, the passivation anti-reflection film 40 deposited on the second main surface of the silicon substrate 10 may be a passivation anti-reflection film formed by SiO₂/SiNₓ. Wherein the passivation anti-reflection film formed by SiO₂/SiNₓ is one of a SiO₂ film, a SiNx film and a stacked film composed of a SiO₂ film and a SiNₓ film; the passivation anti-reflection film 40 deposited on the silicon film 30 may be a passivation anti-reflection film formed by Al₂O₃/SiNₓ. Wherein the passivation anti-reflection film formed by Al₂O₃/SiNₓ is one of an Al₂O₃ film, a SiNₓ film and a stacked film composed of an Al₂O₃ film and a SiNₓ film.

Wherein the thickness of the passivation anti-reflection film ranges from 30 to 300 nm. That is, the thickness of the passivation anti-reflection film may be any value between 30 nm and 300 nm. Controlling the thickness of the passivation anti-reflection film within the range of 30-300 nm may effectively ensure the photoelectric performance of the solar cell.

Wherein the refractive index of the passivation anti-reflection film ranges from 1.2 to 2.8. That is, the refractive index of the passivation anti-reflection film may be any value between 1.2 and 2.8. Controlling the refractive index of the passivation anti-reflection film within the range of 1.2-2.8 may effectively ensure the photoelectric performance of the solar cell.

The aforesaid deposition of the passivation anti-reflection film may also be achieved by using the plasma enhanced chemical vapor deposition (PECVD).

It is worth noting that the aforesaid preparation method for a solar cell may further comprise selecting the silicon substrate 10 (the n-type silicon substrate or the p-type silicon substrate), cleaning the surfaces of the silicon substrate 10, and making a textured surface on the front surface of the silicon substrate 10, as shown in FIG. 2 to FIG. 9.

In the aforesaid embodiment as shown in FIG. 1, by growing a dielectric layer on the first main surface of the silicon substrate and forming a silicon film having the first conductive characteristic on the dielectric layer, the first conductive characteristic of the solar cell may be preliminarily formed, and further the conductive characteristic of the first region included in the silicon film is transformed from the first conductive characteristic to the second conductive characteristic, the first conductive characteristic being opposite to the second conductive characteristic, thereby achieving that a second region having the first conductive characteristic and a first region having the second conductive characteristic are prepared in the same silicon film, which effectively simplifies the FRC cell manufacturing process, and effectively improves the FRC cell production efficiency.

In addition, since the first region having the first conductive characteristic and the second region having the second conductive characteristic belong to the same silicon film, by transforming the conductive characteristic of the first region from the first conductive characteristic to the second conductive characteristic without complicated processes such as photolithography masking, laser etching, secondary diffusion, etc., the FRC cell is made to be more conducive to industrialization and mass production.

In addition, the dielectric layer has a significant electrical performance and may obtain a low contact resistivity and low surface recombination at the same time, which solves the problem of a poor passivation effect on the first main surface of the silicon substrate. The passivation quality will have an impact a hidden open circuit voltage, a dark saturation current density, short-wavelength internal quantum efficiency and other performances of a solar cell. The embodiment of the disclosure may effectively improve a passivation effect of an FBC cell by means of a dielectric layer, so the hidden open circuit voltage, the dark saturation current density, the short-wavelength internal quantum efficiency and other performances of the FBC cell can be improved.

In addition, since the FBC cell preparation process provided by the embodiment of the disclosure is simple and easy to operate, and requires no special processing by precision devices and masks having specific structures, the solution provided by the embodiment of the disclosure can achieve mass production.

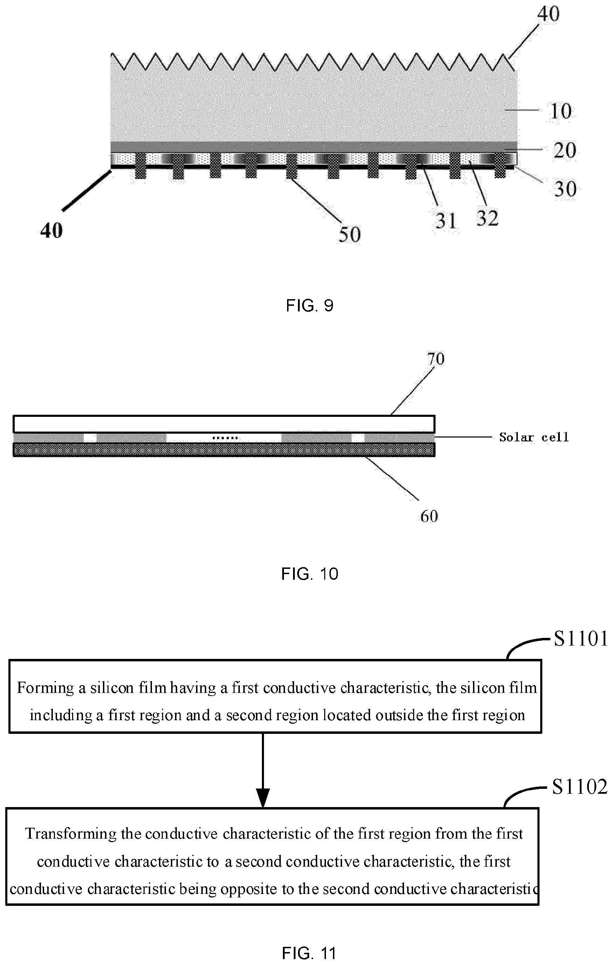

In the embodiment of the disclosure, the preparation method for a solar cell may further comprise: preparing metal electrodes 50 in the first region 31 and the second region 32, and performing sintering to achieve an ohmic contact. Metal gate lines are provided as the metal electrodes 50 in the first region 31 and the second region 32. As shown in the schematic diagram of the cross-section of the solar cell in FIG. 9, the metal gate lines serve as the metal electrodes 50 and are distributed in the first region and the second region (the p+ doped layer and the n+ doped layer), and the metal electrodes 50 are made to be in contact with the rear surface of the silicon substrate 10. As shown in the schematic diagram of a cross-section of the solar cell in FIG. 9, as for a case where the silicon substrate 10 is an n-type silicon substrate, the first type of doping material is a material such as boron that generates holes, and the second type of doping material is a material such as phosphorus that generates free electrons, and correspondingly, the first region is an n+ doped region having the N-type conductive characteristic, and the second region is a p+ doped region having the P-type conductive characteristic, the metal electrodes 50 distributed in the p+ doped region (the second region) pass through the p+ doped region and are in ohmic contact with the rear surface of the n-type silicon substrate; the metal electrodes 50 distributed in the n+ doped region (the first region) pass through the n+ doped region (the first region) and are in contact with the dielectric layer 20. As for a case where the silicon substrate 10 is a p-type silicon substrate, the first type of doping material is a material such as phosphorus that generates free electrons, and the second type of doping material is a material such as boron that generates holes, and correspondingly, the first region is a p+ doped region having the P-type conductive characteristic, and the second region is an n+ doped region with N-type conductive characteristic, the metal electrodes 50 distributed in the n+ doped region (the first region) pass through the n+ doped region and are in ohmic contact with the rear surface of the p-type silicon substrate; the metal electrodes 50 distributed in the p+ doped region (the second region) pass through the n+ doped region (the first region) and are in contact with the dielectric layer 20.

The sintering temperature ranges from 750 to 1000°C. By controlling the sintering temperature between 750 and 1000°C, the stability of the metal electrode may be ensured.

In addition, the metal electrodes in the first region and the electrodes in the second region may be made of different metal materials.

As shown in FIGS. 6B to 9, the embodiment of the disclosure provides a solar cell, which may comprise: a silicon substrate 10, a dielectric layer 20 and a silicon film 30, wherein,
the dielectric layer 20 is provided on the first main surface of the silicon substrate (10); the silicon film 30 is provided on the dielectric layer 20;
the silicon film 30 may include: first regions 31 and second regions 32 that are arranged alternately, the second region 32 having the first conductive characteristic, the first region 31 having the second conductive characteristic, the first conductive characteristic being opposite to the second conductive characteristic; the first region 31 and the second region 32 that are adjacent are electrically isolated.

Since the solar cell provided by the embodiment of the disclosure makes the doping materials having opposite conductive characteristics offset by means of the conductive characteristics by controlling that the regions of the silicon film are doped with different doping materials, and the regions having opposite conductive characteristics are arranged alternately on the same silicon film, so that an electrical isolation region is formed between the first region and the second region. On this basis, the solar cell provided by the disclosure is not required to specifically provide isolation between the first region and the second region, which omits a step of providing isolation between the first region and the second region, and meanwhile the first region and the second region are manufactured on the same silicon film, which may reduce a masking step. Thus, the solar cell provided by the embodiment of the disclosure has a simple structure and is easily industrialized.

In the embodiment of the disclosure, as shown in FIG. 7, the second region 32 includes: a main conductive region 321 and an isolation region 322, wherein the main conductive region 321 has a first conductive characteristic and is doped with a first type of doping material; the isolation region 322 is provided on a side close to the adjacent first region 31; the isolation region 322 has an electrical isolation characteristic and is doped with the first type of doping material and the second type of doping material; the first region 31 is doped with the first type of doping material and the second type of doping material. The conductive characteristic of the first type of doping material and the conductive characteristic of the second type of doping material in the isolation region 322 offset each other, so that the isolation region 322 achieves electrical isolation.

In the embodiment of the disclosure, the first type of doping material is a doping material that forms an N-type conductive characteristic, and the second type of doping material is a doping material that forms a P-type conductive characteristic; or, the first type of doping material is a doping material that forms a P-type conductive characteristic, and the second type of doping material is a doping material that forms an N-type conductive characteristic. Wherein the doping material having the P-type conductive characteristic refers to a material such as boron with which the silicon film is doped and which can generate holes. The doping material having the N-type conductive characteristic refers to a material such as phosphorus with which the silicon film is doped and which can generate free electrons.

In the embodiment of the disclosure, the dielectric layer 20 may include: a single-layer dielectric film or a stacked dielectric film, wherein the single-layer dielectric film or the stacked dielectric film may include: one or more of silicon oxide, titanium oxide and silicon oxynitride. The dielectric layer may ensure the photoelectric performance of the solar cell.

In the embodiment of the disclosure, the thickness of the single-layer dielectric film or the stacked dielectric film ranges from 0.5 nm to 2.5 nm, and within the thickness range, the single-layer dielectric film or the stacked dielectric film may make the performance of the solar cell achieve a comparatively good state.

In the embodiment of the disclosure, the silicon film 30 may include: a single-layer film or a stacked film formed of one or more of microcrystalline silicon, amorphous silicon, and polycrystalline silicon. Wherein the single-layer film or the stacked film formed of one or more of microcrystalline silicon, amorphous silicon, and polycrystalline silicon may include silicon oxide and/or silicon carbide. The silicon film may provide a conductive basis for the first region and the second region of the solar cell.

In the embodiment of the disclosure, the doping concentration of the first type of doping material in the silicon film ranges from 1.0×10¹⁹ atoms/cm³ to 2.0×10²¹ atoms/cm³; the doping concentration of the second type of doping material in the silicon film ranges from 1.0×10¹⁹ atoms/cm³ to 2.0×10²¹ atoms/cm³; it is worth noting that the doping concentration of the second type of doping material in the silicon film is generally not lower than the doping concentration of the first type of doping material in the silicon film so as to achieve the transformation of the conductive characteristic of the first region. The first type of doping material is distributed in the thickness direction of the silicon film, so the measurement unit of the doping concentration of the first type of doping material is generally atoms/cm³. The second type of doping material implanted into the first region in an ion implantation manner is mainly distributed on the surface of the silicon film before activation, so the measurement unit of the second type of doping material implanted in an ion implantation manner (before activation) is generally atoms/cm². That the doping concentration of the second type of doping material is greater than the doping concentration of the first type of doping material as mentioned above may refer to that the doping concentration after converting the measurement unit of the second type of doping material implanted in an ion implantation manner (before activation) from atoms/cm² to atoms/cm³ according to the thickness of the silicon film and the area of the first region is greater than the doping concentration of the first type of doping material; and may also refer to that after the second doping material and the first doping material are activated, the doping concentration of the second doping material in the middle region of the first region is greater than the doping concentration of the first type of doping material. The middle region of the first region refers to a region covered by an ion beam in the process of implanting the second doping material in an ion implantation manner.

The essence of the fact that the doping concentration of the second type of doping material is greater than the doping concentration of the first type of doping material is that the number of holes generated by the second type of doping material in the first region is greater than the number of free electrons generated by the first type of doping material in the first region, or, the number of free electrons generated by the second type of doping material in the first region is greater than the number of holes generated by the first type of doping material in the first region.

In addition, since the ion implantation manner will cause the concentration of the middle region to be high, the aforesaid doping concentration of the second type of doping material refers to an average concentration of the middle region K in the first region 31 as shown in FIG. 6.

In addition, after a part of the second type of doping material offsets the conductive characteristic of the first type of doping material, the remaining part can exhibit the second conductive characteristic, and the aforesaid doping concentration of the second type of doping material in the silicon film refers to a doping concentration of the first type of doping material of the remaining part that can exhibit the second conductive characteristic.

In the embodiment of the disclosure, as shown in FIG. 8, passivation anti-reflection films 40 are provided on the second main surface of the silicon substrate 10 and the silicon film 30, respectively.

Wherein the passivation anti-reflection film 40 may include: any one or more of silicon nitride, silicon oxide, silicon oxynitride and aluminum oxide.

In the embodiment of the disclosure, the passivation anti-reflection film 40 provided on the second main surface of the silicon substrate 10 may be a passivation anti-reflection film formed by SiO₂/SiNₓ.

In the embodiment of the disclosure, the passivation anti-reflection film 40 provided on the silicon film 30 is a passivation anti-reflection film formed by Al₂O₃/SiNₓ.

In the embodiment of the disclosure, the thickness of the passivation anti-reflection film 40 ranges from 30 to 300 nm.

In the embodiment of the disclosure, the refractive index of the passivation anti-reflection film 40 ranges from 1.2 to 2.8.

In the embodiment of the disclosure, as shown in FIG. 9, the solar cell may further include: metal electrodes 50 provided in the main conductive region 321 and the first region 31, respectively.

As shown in FIG. 10, the embodiment of the disclosure provides a solar cell component. The solar cell component may include: a rear plate 60, a cover plate 70 and a plurality of solar cells provided in any of the aforesaid embodiments, wherein,

the plurality of solar cells are packaged between the rear plate 60 and the cover plate 70.

It is worth noting that the solar cell or the solar cells used in the solar cell component in each of the aforesaid embodiments may be obtained by the preparation method as shown in FIG. 1 and solutions related to the preparation method as shown in FIG. 1.

As shown in FIG. 11, the embodiment of the disclosure provides a preparation method for a silicon film, which may comprise the following steps:
Step S1101: Forming a silicon film having a first conductive characteristic, the silicon film including a first region and a second region located outside the first region;
In the above step, the silicon film is mainly doped with the first type of doping material in an in-situ doping manner to form a silicon film having the first conductive characteristic.

Step S1102: Transforming the conductive characteristic of the first region from the first conductive characteristic to a second conductive characteristic, the first conductive characteristic being opposite to the second conductive characteristic.

In the above step, the first region is mainly doped with the second type of doping material in an ion implantation manner; the doping concentration of the second type of doping material is greater than the doping concentration of the first type of doping material, thereby transforming the conductive characteristic of the first region from the first conductive characteristic to the second conductive characteristic. For example, the first type of doping material is a doping material that forms an N-type conductive characteristic, and the second type of doping material is a doping material that forms a P-type conductive characteristic; for another example, the first type of doping material is a doping material that forms a P-type conductive characteristic, and the second type of doping material is a doping material that forms an N-type conductive characteristic. The essence of the fact that the doping concentration of the second type of doping material is greater than the doping concentration of the first type of doping material is that the number of holes generated by the second type of doping material in the first region is greater than the number of free electrons generated by the first type of doping material in the first region, or, the number of free electrons generated by the second type of doping material in the first region is greater than the number of holes generated by the first type of doping material in the first region.

In addition, the doping materials (the first doping material and the second doping material) with which the silicon film is doped may also be activated in an annealing manner.

It is worth noting that the preparation method for a silicon film may select to use the preparation manner, preparation parameters, preparation conditions and the like of the silicon film involved in the aforesaid preparation method for a solar cell, and no unnecessary details are further given herein.

A silicon film with regions having different conductive types may be obtained by the aforesaid process, which silicon film may be provided in a solar cell as shown in FIG. 6B to FIG. 9 or provided in other semiconductor devices.

The specific preparation process of applying the silicon film to the solar cell and combining the silicon film with the solar cell is described in detail below with various specific embodiments.

### Embodiment 1

A1: Selecting a qualified n-type silicon substrate, cleaning the surfaces of the n-type silicon substrate, and making a textured surface.

A2: Preparing a dielectric layer: an LPCVD device is used to grow a 1.5 nm oxide layer (SiO₂) in situ on the n-type silicon substrate 10, the grown oxide layer being just the dielectric layer 20.

A3: Preparing a crystalline silicon film doped in situ: on the n-type silicon substrate 10 on which the dielectric layer 20 has been grown, in the PECVD device, a layer of 125 nm polysilicon film 30 (that is, a silicon film) doped with phosphorus (P) in situ is further grown on the dielectric layer (SiO₂ oxide layer) at a temperature of 610°C, the doping concentration of phosphorus being 1.0×10¹⁹ atoms/cm³.

A4: Changing a conductive characteristic in an region obtained by division: part of the region (that is, the second region) of the polysilicon film 30 is covered by a template, the uncovered part being the first region, and an ion implanter is used to perform localized implantation of the doping element boron (B) into the silicon film doped with P in situ (that is, the doping element 8 is implanted into the first region in an ion implantation manner) to achieve the transformation of the doping conductive characteristic in the first region of the polysilicon film, wherein the doping dose of boron used for ion implantation is 2×10¹⁵ atoms/cm². The doping dose of boron may ensure the transformation of the conductive characteristic of the first region.

A5: Activating doping elements: the doping elements (phosphorus and boron) are activated using a temperature of 950°C, and meanwhile a sub-high temperature also achieves crystallization heat treatment of the polysilicon film grown by the PECVD, which further improves the performance of the film.

A6: Preparing passivation anti-reflection films: the PECVD device is then used to coat a layer of silicon nitride film on the upper surface of the silicon substrate 10 and the silicon film, respectively, the coating temperature being 450°C, the film thickness being 80 nm, the refractive index of the film being 2.0, and the reflectivity of the film being 3.5%.

A7: Preparing electrodes: a screen printing technique is used for precise alignment, silver aluminum paste and silver paste are printed in the first region (p+ doped region) and the second region (n+ doped region), respectively, and sintering is performed at a temperature of 870°C to form an ohmic contact in order to obtain metal electrodes.

### Embodiment 2

Steps B1 to B7 are the same as the steps A1 to A7 in Embodiment 1, and no unnecessary details are further given herein.

Wherein,
In the process of preparing an ultra-thin dielectric layer in the step B2, a 1.0 nm silicon oxynitride dielectric layer is grown in situ on the silicon substrate.

In the step B3, the crystalline silicon film doped in situ is prepared, the temperature is adjusted to 700°C, a 125 nm stacked silicon film of silicon oxide and silicon carbide is further grown on the silicon oxynitride dielectric layer, and the stacked silicon film of silicon oxide and silicon carbide is doped with phosphorus in situ, the doping concentration being 1.0×10¹⁹ atoms/cm³.

In the step B4, the conductive characteristic in the region obtained by division is changed, and the doping dose of boron is 3×10¹⁵ atoms/cm². The doping dose of boron may ensure the transformation of the conductive characteristic of the first region.

In the step B5, the doping elements are activated, so a temperature of 850°C is selected to perform the activation of the doping elements.

In the step B6, the passivation anti-reflection films are prepared, so a film which formed a stacked film by silicon oxynitride and aluminum oxide is coated on the surface of the silicon wafer, the coating temperature being 450°C, the film thickness being 100 nm, the refractive index of the film being 2.5, and the reflectivity of the film being 3%.

In the step B7, sintering is performed at a temperature of 1000°C to form an ohmic contact.

### Embodiment 3

Steps C1 to C7 are the same as the steps A1 to A7 in Embodiment 1, and no unnecessary details are further given herein.

Wherein,
In the process of preparing an ultra-thin dielectric layer in the step C2, a 1.0 nm stacked dielectric layer composed of titanium oxide and silicon oxynitride is grown in situ on the silicon substrate.

In the step C3, the crystalline silicon film doped in situ is prepared, the temperature is adjusted to 800°C, a 200 nm stacked silicon film of silicon oxide and silicon carbide is further grown on the silicon oxynitride dielectric layer, and the stacked silicon film of silicon oxide and silicon carbide is doped with phosphorus in situ, the doping concentration being 5.0×10¹⁹ atoms/cm³.

In the step C4, the conductive characteristic in the region obtained by division is changed, and the doping dose of boron is 7×10¹⁵ atoms/cm². The doping dose of boron may ensure the transformation of the conductive characteristic of the first region.

In the step C5, the doping elements are activated, so a temperature of 950°C is selected to perform the activation of the doping elements.

In the step C6, the passivation anti-reflection films are prepared, so a film which formed a stacked film by silicon nitride, silicon oxide and silicon oxynitride is coated on the surface of the silicon wafer, the coating temperature being 550°C, the film thickness being 150 nm, the refractive index of the film being 2.7, and the reflectivity of the film being 3.5%.

In the step C7, sintering is performed at a temperature of 900°C to form an ohmic contact.

### Embodiment 4

D1: Selecting a qualified p-type silicon substrate, cleaning the surfaces of the p-type silicon substrate, and making a textured surface.

D2: Preparing a dielectric layer: a low pressure chemical vapor deposition (LPCVD) device is used to grow a 2 nm dielectric layer (silicon oxide and silicon oxynitride) in situ on the p-type silicon substrate.

D3: Preparing a crystalline silicon film doped in situ: on the p-type silicon substrate 10 on which the dielectric layer 20 has been grown, in the PECVD device, a layer of 125 nm polysilicon film 30 (that is, a silicon film) doped with boron (B) in situ is further grown on the dielectric layer (a dielectric layer composed of a SiO² oxide layer and silicon oxynitride) at a temperature of 610°C, the doping concentration of boron being 1.0×10¹⁹ atoms/cm³.

D4: Changing a conductive characteristic in a region obtained by division: part of the region (that is, the second region) of the polysilicon film 30 is covered by a template, the uncovered part being the first region, and an ion implanter is used to perform localized implantation of the doping element phosphorus (P) into the silicon film doped with boron in situ (that is, the doping element phosphorus is implanted into the first region in an ion implantation manner) to achieve the transformation of the doping conductive characteristic in the first region of the polysilicon film, wherein the doping dose of phosphorus used for ion implantation is 2×10¹⁵ atoms/cm². The doping dose of phosphorus may ensure the transformation of the conductive characteristic of the first region.

D5: Activating doping elements: the doping elements (phosphorus and boron) are activated using a temperature of 1000°C, and meanwhile a sub-high temperature also achieves crystallization heat treatment of the polysilicon film grown by the PECVD, which further improves the performance of the film.

D6: Preparing passivation anti-reflection films: the PECVD device is then used to coat a layer of silicon nitride film on the surface of the silicon wafer, the coating temperature being 650°C, the film thickness being 150 nm, the refractive index of the film being 3.0, and the reflectivity of the film being 3.5%.

D7: Preparing electrodes: a screen printing technique is used for precise alignment, silver aluminum paste and silver paste are printed in the first region (n+ doped region) and the second region (p+ doped region), respectively, and sintering is performed at a temperature of 970°C to form an ohmic contact in order to obtain metal electrodes.

The introductions provided by the aforesaid steps are only used to help the understanding of the structure, method and core idea of the disclosure. Those skilled in the art may make several improvements and modifications of the disclosure without departing from the principle of the disclosure, and these improvements and modifications also fall within the scopes of protection of the claims of the disclosure.

## Claims

1. A preparation method for a solar cell, comprising:
step (a): forming a dielectric layer (20) on a first main surface of a silicon substrate (10);
step (b): forming a silicon film (30) having a first conductive characteristic on the dielectric layer (20), the silicon film including a first region (31) and a second region (32) located outside the first region (31); and
step (c): transforming the conductive characteristic of the first region (31) from the first conductive characteristic to a second conductive characteristic, the first conductive characteristic being opposite to the second conductive characteristic.

2. The preparation method of claim 1, wherein the step (b) further comprises:
step (b1): dividing the silicon film (30) into the first region (31) and the second region (32).

3. The preparation method of claim 1 or 2, wherein
the silicon film includes a plurality of first regions (31) and a plurality of second regions (32);
the plurality of first regions (31) and the plurality of second regions (32) are arranged alternately.

4. The preparation method of claim 1, wherein the step (b) further comprises:
step (b2): depositing a silicon film having a first type of doping material on the dielectric layer (20).

5. The preparation method of claim 4, wherein the step (b2) comprises:
step (b21): depositing a silicon film on the dielectric layer (20); and
step (b22): doping the silicon film with the first type of doping material in an in-situ doping manner.

6. The preparation method of claim 5, wherein the step (c) comprises:
doping the first region (31) with a second type of doping material in an ion implantation manner, the doping concentration of the second type of doping material being greater than the doping concentration of the first type of doping material.

7. The preparation method of claim 6, wherein the method further comprises:
activating the doping material with which the silicon film is doped in an annealing manner.

8. The preparation method of claim 6, wherein
the first type of doping material is a doping material that forms an N-type conductive characteristic, and the second type of doping material is a doping material that forms a P-type conductive characteristic;
or,
the first type of doping material is a doping material that forms a P-type conductive characteristic, and the second type of doping material is a doping material that forms an N-type conductive characteristic.

9. The preparation method of claim 8, wherein
the doping concentration of the first type of doping material in the silicon film is 1.0×10¹⁹ atoms/cm³-2.0×10²¹ atoms/cm³;
and/or,
the doping concentration of the second type of doping material in the second region of the silicon film is 1.0×10¹⁹ atoms/cm³-2.0×10²¹ atoms/cm³.

10. The preparation method of claim 1, wherein the step (a) comprises:
forming a single-layer dielectric film or a stacked dielectric film on the first main surface of the silicon substrate (10) in a low pressure chemical deposition manner, wherein the single-layer dielectric film or the stacked dielectric film includes: one or more of silicon oxide, titanium oxide and silicon oxynitride.

11. The preparation method of 10, wherein
the thickness of the single-layer dielectric film or the stacked dielectric film ranges from 0.5 nm to 2.5 nm.

12. The preparation method of any of claims 1, 2, 4 and 5, wherein
the silicon film includes: a single-layer film or a stacked film formed of one or more of microcrystalline silicon, amorphous silicon, and polycrystalline silicon.

13. The preparation method of any of claims 1, 2, 4 and 5 to 11, wherein after the step (c), the method further comprises:
depositing passivation anti-reflection films (40) on the silicon film (30) and a second main surface of the silicon substrate (10), respectively.

14. The preparation method of claim 13, wherein the passivation anti-reflection film includes:
any one or more of silicon nitride, silicon oxide, silicon oxynitride and aluminum oxide.

15. The preparation method of claim 13, wherein
the thickness of the passivation anti-reflection film ranges from 30 to 300 nm;
and/or,
the refractive index of the passivation anti-reflection film ranges from 1.2 to 2.8.

16. The preparation method of claim 13, wherein the method further comprises:
preparing metal electrodes (50) in the first region and the second region, and performing sintering to achieve an ohmic contact.

17. The preparation method of claim 12, wherein
the silicon film further includes: silicon oxide and/or silicon carbide.

18. A preparation method for a silicon film, wherein the method comprises:
step (a'): forming a silicon film (30) having a first conductive characteristic, the silicon film including a first region (31) and a second region (32) located outside the first region; and
step (b'): transforming the conductive characteristic of the first region (31) from the first conductive characteristic to a second conductive characteristic, the first conductive characteristic being opposite to the second conductive characteristic.

19. The preparation method of claim 18, wherein,
in the step (a'), the silicon film is doped with a first type of doping material in an in-situ doping manner.

20. The preparation method of claim 18, wherein,
in the step (b'), the first region (31) is doped with a second type of doping material in an ion implantation manner; the doping concentration of the second type of doping material is greater than the doping concentration of the first doping material.
